# EUROPEAN PATENT APPLICATION

(11) **EP 4 790 497 A1**
(43) Date of publication of application: **12.08.2026**
(21) Application number: 25305190.8
(22) Date of filing: 11.02.2025
(51) Int. Cl.: G05B 19/04

(54) **METHODS FOR CONFIGURING A SOURCE APPARATUS AND APPARATUSES FOR IMPLEMENTING THE SAME**

(71) Applicant: SCHNEIDER ELECTRIC INDUSTRIES SAS, 92500 Rueil-Malmaison (FR)
(72) Inventor: FRUCHARD, Bertrand, 16340 L'ISLE D'ESPAGNAC (FR); ROBELIN, Arnaud, 16170 VAL D'AUGE (FR); LEBAD, Ammar, 16000 ANGOULEME (FR); HINTZY, Julien, 16130 CHAMPNIERS (FR)
(74) Representative: Plasseraud IP

(57) **Abstract**

A method for configuring a source apparatus adapted for processing an analog electrical output signal output to a receptor apparatus, is proposed, which comprises, the source apparatus being electrically coupled to the receptor apparatus through an output interface comprising a first and second output signal terminals of the source apparatus: configure the output interface of the device to be an analog current output; obtaining one or more measured voltages respectively corresponding to one or more respective current values of a current signal output by the analog current output; and performing a determination of a type of an analog electrical output signal output by the analog current output, based on the one or more measured voltages.

## Description

The present disclosure relates to the configuration of a source apparatus adapted for processing an analog electrical output signal output to a receptor apparatus, in particular to the configuration of an analog output apparatus on which a receptor apparatus is connected.

When using an industrial analog output product, for example for connecting an analog actuator, the user must choose manually the appropriate input or product reference suitable for their analog actuator.

There are two major families of analog actuators: actuators providing information in electric current (amperes) and actuators providing information in the form of electric voltage (volts).

As a consequence, in order to cover different use cases, manufacturers of analog output products (apparatuses/devices) offer either products with both types of outputs (voltage and current outputs) or two separate product references.

There is therefore a need for providing improved schemes for configuring an analog output apparatus and apparatuses implementing the same that address at least some of the above-described drawbacks and shortcomings of the conventional technology in the art.

It is an object of the present subject disclosure to provide improved schemes for configuring an analog output apparatus and apparatuses implementing the same.

Another object of the present subject disclosure is to provide an improved scheme for configuring a source apparatus adapted for processing an analog electrical output signal outputted to a receptor apparatus (e.g. an actuator apparatus) and apparatus implementing the same for alleviating the above-described drawbacks and shortcomings of conventional schemes.

To achieve these objects and other advantages and in accordance with the purpose of the present subject disclosure, as embodied and broadly described herein, in one aspect of the present subject disclosure, a method for configuring a source apparatus adapted for processing an analog electrical output signal outputted to a receptor apparatus (e.g. an actuator). The proposed method comprises, the source apparatus being electrically coupled to the receptor apparatus through an output interface comprising a first and second output signal terminals of the source apparatus (so that the analog electrical output signal is fed by the source apparatus to the receptor apparatus): Configuring the output interface of the device to be an analog current output; obtaining one or more measured voltages respectively corresponding to one or more respective current values of a current signal injected in (output to) the receptor apparatus through the analog current output; and performing a determination of a type of an analog electrical output signal to be output by the output interface, based on the one or more measured voltages.

In one or more embodiments, the proposed method further comprise: configuring the output interface based on the determined type of the analog electrical output signal.

In one or more embodiments, the type of the analog electrical output signal may be one of an analog current output signal and an analog voltage output signal.

The proposed scheme advantageously allows an autodetection and configuration of an analog output product with respect to whether an analog output electrical signal fed by the analog output product to a receptor apparatus (e.g. an actuator) is a (analog) voltage signal or a (analog) current signal.

In particular, an analog output implementing one or more embodiments of the proposed scheme may advantageously automatically detect whether an analog output electrical signal fed by the analog output product is a voltage signal or a current signal, and perform auto-configuration according to the detected type of analog output product.

As a consequence, the present subject disclosure provides an improved analog output device (source apparatus) which advantageously exhibits versatility with respect to the type of analog output electrical signal fed by the improved analog output device to a receptor apparatus (e.g. an actuator). The improved analog output device may therefore be capable of, for example during an initialization phase after being coupled to a receptor apparatus, determining the type of analog signal (between a current analog signal and a voltage analog signal) with which the recipient apparatus is configured to operate (which the recipient apparatus is configured to receive as input signal). In addition, the improved analog output device (apparatus) of the present subject disclosure may in some embodiments be self-configurable accordingly.

The proposed scheme is therefore particularly advantageous for the deployment of analog output devices that are capable of adapting to the type of an actuator connected to the analog output device with respect to whether the actuator is configured to receive a voltage signal or a current signal provided as analog electrical output signal fed by the analog output device.

In addition, the proposed improved schemes and apparatuses advantageously allow interchangeability of the receptor apparatus connected to an improved apparatus, so that a receptor apparatus receiving an analog electrical signal of a given type (e.g. current or voltage) connected to an improved apparatus of the present subject disclosure may be replaced by another receptor apparatus which may be configured to receive as input an analog electrical signal of a different type. Upon connecting the other receptor apparatus to the improved apparatus, the improved apparatus may advantageously automatically detect the type of analog electrical signal expected as input by the other receptor apparatus, and in some embodiments may auto-configure accordingly.

Further, advantageously, the improved schemes and apparatuses of the present subject disclosure alleviate the need for a user to select a specific analog output device product reference which is specifically adapted to an application (e.g. which is adapted to the signal output (fed) to a receptor apparatus (e.g. an actuator) to be connected (electrically coupled) to an improved apparatus of the present subject disclosure). Such auto-detection feature of the type of analog output electrical signal fed to a receptor apparatus and - in some embodiments - auto-configuration feature also advantageously open the path for configuring the improved apparatus for protecting the receptor apparatus.

In one or more embodiments, performing the determination of the type of the analog electrical output signal output by the analog current output may comprise: determining, based on the one or more measured voltages, that the output interface of the source apparatus is to be configured as an analog current output. In some embodiments, the proposed method may further comprise: configure the output interface of the source apparatus to be an analog current output.

In one or more embodiments, performing the determination of the type of the analog electrical output signal output by the analog current output may comprise: determining, based on the one or more measured voltages, that the output interface of the source apparatus is to be configured as an analog voltage output. In some embodiments, the proposed method may further comprise: configure the output interface of the source apparatus to be an analog voltage output.

In one or more embodiments, performing the determination of the type of the analog electrical output signal output by the analog current output may comprise: determining, based on the one or more measured voltages, whether the output interface of the source apparatus is to be configured as an analog current output or an analog voltage output.

In one or more embodiments, performing the determination of the type of the analog electrical output signal output by the analog current output may result in an error based on that no determination can be made as to whether the output interface of the source apparatus is to be configured as an analog current output or an analog voltage output.

In one or more embodiments, obtaining the one or more measured voltages may comprise performing a configuration loop, which may in some embodiments comprise: Configuring the analog current output to output a current signal of a predefined initial current value; Performing one or more iterations of the configuration loop. In some embodiments, an iteration of the configuration loop may comprise: for a present iteration current value of the current signal output by the analog current output, performing a current injection to the receptor apparatus of a current value corresponding to the present iteration current value, and obtaining a measured voltage by performing a voltage measurement of a voltage at the output interface of the source apparatus.

In some embodiments, an iteration of the configuration loop may further comprise: storing in a memory the measured voltage in association with the present iteration current value.

In some embodiments, an iteration of the configuration loop may further comprise: Based on determining that the present iteration current value is inferior to a predefined current threshold value, incrementing the present iteration current value by a predefined configuration loop current value step; Otherwise exiting the configuration loop.

In one or more embodiments, the voltage measurement may be performed between a first terminal and a second terminal of the output interface through which the external device is coupled to the source apparatus.

In one or more embodiments, the proposed method may further comprise: determining one or more scores respectively representing a current score, a voltage score, and an indetermined score based on the one or more measured voltages, wherein the determination of the type of analog electrical output signal to be output by the output interface is based on the one or more scores.

In some embodiments, the proposed method may further comprise: determining, for an injected current value of the one or more respective current values of the current signal injected in the receptor apparatus, a representative voltage value based on the one or more measured voltages that correspond to the injected current value. In some embodiments, the determination of the type of analog electrical output signal to be output by the output interface may comprise comparing the representative voltage value with a threshold.

In another aspect of the present subject disclosure, an apparatus is proposed, which comprises a processor and a memory operatively coupled to the processor, wherein the apparatus is configured to perform a method as proposed in the present subject disclosure.

In yet another aspect of the present subject disclosure, a non-transitory computer-readable medium encoded with executable instructions which, when executed, causes an apparatus comprising a processor operatively coupled with a memory, to perform a method as proposed in the present subject disclosure, is proposed.

In yet another aspect of the present subject disclosure, a computer program product comprising computer program code tangibly embodied in a computer readable medium, said computer program code comprising instructions to, when provided to a computer system and executed, cause said computer to perform a method as proposed in the present subject disclosure, is proposed. In another aspect of the present subject disclosure, a data set representing, for example through compression or encoding, a computer program as proposed herein, is proposed.

It should be appreciated that the present subject disclosure can be implemented and utilized in numerous ways, including without limitation as a process, an apparatus, a system, a device, and as a method for applications now known and later developed. These and other unique features of the system disclosed herein will become more readily apparent from the following description and the accompanying drawings.

### Brief description of the drawings

The present subject disclosure will be better understood and its numerous objects and advantages will become more apparent to those skilled in the art by reference to the following drawings, in conjunction with the accompanying specification, in which:
Figure 1 shows an exemplary industrial network according to one or more embodiments of the present subject disclosure;
Figure 2 illustrates an exemplary scheme for configuring a source apparatus according to one or more embodiments of the present subject disclosure;
Figure 3 illustrates an apparatus according to one or more embodiments of the present subject disclosure;
Figures. 4A and 4B show a flow diagram illustrating a method for self-configuring a source apparatus according to one or more embodiments of the present subject disclosure;
Figure 5 shows a flow diagram illustrating a method for self-configuring a source apparatus according to one or more embodiments of the present subject disclosure;
Figure 6 shows a flow diagram illustrating a method for self-configuring a source apparatus according to one or more embodiments of the present subject disclosure and
Figures 7a and 7b illustrate an apparatus according to one or more embodiments of the present subject disclosure.

### Description of embodiments

For simplicity and clarity of illustration, the drawing figures illustrate the general manner of construction, and descriptions and details of well-known features and techniques may be omitted to avoid unnecessarily obscuring the discussion of the described embodiments of the invention. Additionally, elements in the drawing figures are not necessarily drawn to scale. For example, the dimensions of some of the elements in the figures may be exaggerated relative to other elements to help improve understanding of embodiments of the present invention. Certain figures may be shown in an idealized fashion in order to aid understanding, such as when structures are shown having straight lines, sharp angles, and/or parallel planes or the like that under real-world conditions would likely be significantly less symmetric and orderly. The same reference numerals in different figures denote the same elements, while similar reference numerals may, but do not necessarily, denote similar elements.

In addition, it should be apparent that the teaching herein can be embodied in a wide variety of forms and that any specific structure and/or function disclosed herein is merely representative. In particular, one skilled in the art will appreciate that an aspect disclosed herein can be implemented independently of any other aspects and that several aspects can be combined in various ways.

The present disclosure is described below with reference to apparatuses, devices, modules, units, functions, engines, block diagrams and flowchart illustrations of the methods, systems, and computer program according to one or more exemplary embodiments. Each described apparatus, device, module, unit, function, engine, block of the block diagrams and flowchart illustrations can be implemented in hardware, software, firmware, middleware, microcode, or any suitable combination thereof. If implemented in software, the apparatuses, devices, modules, units, functions, engines, blocks of the block diagrams and/or flowchart illustrations can be implemented by computer program instructions or software code, which may be stored or transmitted over a computer-readable medium, or loaded onto a general purpose computer, special purpose computer or other programmable data processing apparatus to produce a machine, such that the computer program instructions or software code which execute on the computer or other programmable data processing apparatus, create the means for implementing the functions described herein.

Embodiments of computer-readable media includes, but are not limited to, both computer storage media and communication media including any medium that facilitates transfer of a computer program from one place to another. As used herein, a "computer storage media" may be any physical media that can be accessed by a computer or a processor. In addition, the terms « memory » and « computer storage media" include any type of data storage device, such as, without limitation, a hard drive, a flash drive or other flash memory devices (e.g. memory keys, memory sticks, key drive, SSD drives), CD-ROM or other optical storage, DVD, magnetic disk storage or other magnetic storage devices, memory chip(s), Random Access Memory (RAM), Read-Only-Memory (ROM), Electrically Erasable Read-Only-Memory (EEPROM), smart cards, or any other suitable medium that can be used to carry or store program code in the form of instructions or data structures which can be read by a computer processor, or a combination thereof. Also, various forms of computer-readable media may transmit or carry instructions to a computer, including a router, gateway, server, or other transmission device, wired (coaxial cable, fiber, twisted pair, DSL cable) or wireless (infrared, radio, cellular, microwave). The instructions may comprise code from any computer-programming language, including, but not limited to, assembly, C, C++, Python, Visual Basic, SQL, PHP, and JAVA.

Unless specifically stated otherwise, it will be appreciated that throughout the following description discussions utilizing terms such as processing, computing, calculating, determining, or the like, refer to the action or processes of a computer or computing system, or similar electronic computing device, that manipulate or transform data represented as physical, such as electronic, quantities within the registers or memories of the computing system into other data similarly represented as physical quantities within the memories, registers or other such information storage, transmission or display devices of the computing system.

As used herein, the terms "comprise," "include," "have," and any variations thereof, are intended to cover a non-exclusive inclusion, such that a process, method, article, or apparatus that comprises a list of elements is not necessarily limited to those elements, but may include other elements not expressly listed or inherent to such process, method, article, or apparatus.

Additionally, the word "exemplary" is used herein to mean "serving as an example, instance, or illustration". Any embodiment or design described herein as "exemplary" is not necessarily to be construed as preferred or advantageous over other embodiments or designs.

In the present subject disclosure, the terms "coupled" and "connected", along with their derivatives, may be indifferently used to indicate that two or more elements are in direct physical or electrical contact with each other, or two or more elements are not in direct contact with each other, but yet still co-operate or interact with each other.

In the present subject disclosure, the terms "analog", "analog subassembly" and "analog part" are used indiscriminately in this description to refer to subassemblies of one or more electronic components (which are then referred to as "analog") configured to receive and/or process analog signals.

It should be understood that embodiments of the present subject disclosure may be used for configuring an analog output device (apparatus, module) for processing an analog electrical output signal fed to a receptor apparatus to which it is electrically connected (e.g. through one or more electrical terminals), with respect to the type of analog electrical output signal (e.g. voltage input signal or current input signal), in particular, although not limited to, configuring an analog output device (apparatus, module) for processing an analog electrical output signal fed to an actuator apparatus to which it is electrically connected.

In the following, embodiments of the present subject disclosure may be described in reference to the exemplary standard specification IEC 61131-2, for purposes of illustration. However, it will be appreciated by those having ordinary skill in the relevant art that embodiments of the present subject disclosure may be implemented in any suitable apparatus (device), such as for example any suitable analog output device, configured to comply with or to follow specifications of any suitable standard specification(s) other than the standard specification IEC 61131-2 which is given by way of example only.

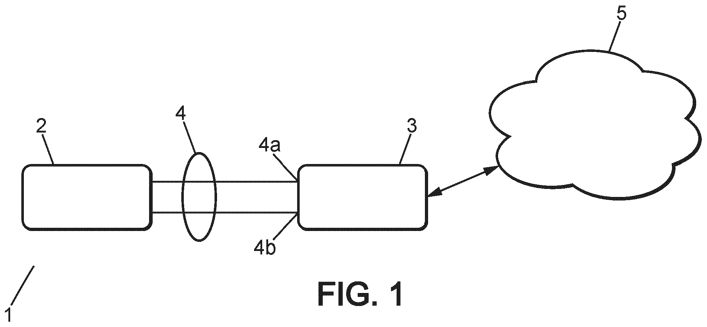

In an industrial network, various nodes may be connected to each other through electrical coupling. For example, in the exemplary industrial network (1) illustrated in Fig. 1, an actuator node (2) may be electrically coupled to an analog output node (3). The actuator node (2) may be configured to receive from the analog output node (3) an analog electrical output signal, which may be fed by the analog output node (3) to the actuator node (2) through two terminals (4a, 4b) of the electrical coupling (4) of the analog output node (3) with the actuator node (2).

In some embodiments, the analog output node (3) may be further connected (including communicatively coupled) to an industrial sub-network (5) of the industrial network (1), for example comprising one or more sensor nodes.

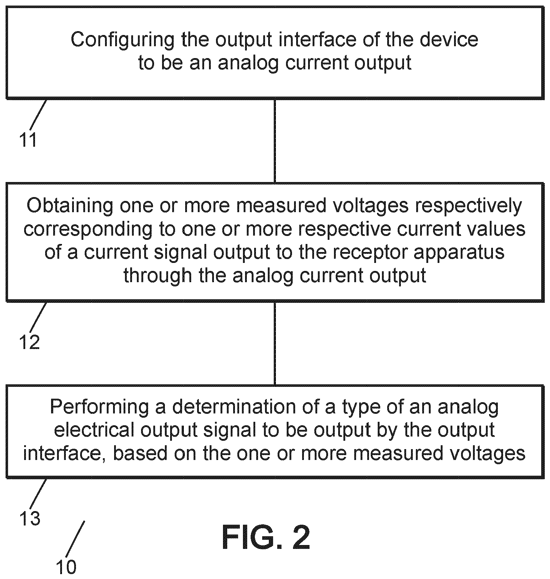

Figure 2 is a diagram that illustrates an exemplary scheme (10) for configuring a source apparatus (e.g. an analog output apparatus) according to one or more embodiments of the present subject disclosure.

One considers a source apparatus adapted for processing an analog electrical output signal fed to a receptor apparatus, such as for example the analog output node (3) and the actuator node (2) shown on Fig. 1. The source apparatus may be electrically coupled to the receptor apparatus, for example through an output interface comprising a first and second output signal terminals of the source apparatus, so that the source apparatus may feed an analog electrical output signal to the receptor apparatus.

In one or more embodiments, the output interface of the source apparatus may be configured (11) to be an analog current output. In some embodiments, configuring the output interface to be an analog current output may comprise configuring the output interface to feed the receptor apparatus coupled to the source apparatus an analog current signal.

In one or more embodiments, a load characterization may be performed, which may comprise obtaining (12) one or more measured voltages respectively corresponding to one or more respective current values of a current signal output (injected) to the receptor apparatus through the analog current output.

In one or more embodiments, the one or more measured voltages may be voltage values measured at the output interface of the source apparatus further to injecting to the receptor apparatus a current signal of one or more respective current values (respectively corresponding to the one or more measured voltages). In some embodiments, one or more voltage measurements may be performed for measuring voltage at the output interface further to injecting to the receptor apparatus a current signal of a current value corresponding to the one or more measured voltages.

In one or more embodiments, a determination of a type of an analog electrical output signal output by the output interface of the source apparatus may be performed (13) by the source apparatus based on the one or more measured voltages obtained by the source apparatus.

In one or more embodiments, different determinations may be performed depending on the receptor apparatus to which the proposed source apparatus may dynamically adapt: in some cases, the source apparatus may determine, based on the one or more measured voltages, that the output interface of the source apparatus is to be configured as an analog current output. In other cases, the source apparatus may determine, based on the one or more measured voltages, that the output interface of the source apparatus is to be configured as an analog voltage output. In yet other cases, the determination based on the one or more measured voltages may result in an error reflecting that no determination can be made as to whether the output interface of the source apparatus is to be configured an analog current output or an analog voltage input.

In some embodiments, in cases where a determination is made that the output interface of the source apparatus is an analog current output based on the one or more measured voltages, the source apparatus may proceed to configure its output interface to be an analog current output. For example, the source apparatus may proceed to configure its output interface to feed an analog current signal to the receptor apparatus coupled to the source apparatus.

In some embodiments, in cases where a determination is made that the output interface of the source apparatus is an analog voltage output based on the one or more measured voltages, the source apparatus may proceed to configure its output interface to be an analog voltage output. For example, the source apparatus may proceed to configure its output interface to feed an analog voltage signal to the receptor apparatus coupled to the source apparatus.

In one or more embodiments, the one or more measured voltages may be obtained by performing operations including performing one or more iterations of a configuration loop for configuration of the source apparatus.

In one or more embodiments, the configuration loop may be initialized, and initialization of the configuration loop may comprise configuring the analog current output to output a current signal of a predefined initial current value.

For example, in some embodiments, the value of the predefined initial current value may be chosen based on rated current values specified for the receptor apparatus, for example in the IEC 61131-2 standard specification (in particular chapter 6.5.2 thereof) for the field of industrial automation.

Specifically, in the exemplary case where the value of the predefined initial current value is chosen based on rated current values specified in chapter 6.5.2 of the IEC 61131-2 specification, the initial current value used for initializing the configuration loop may be predefined to be 1 mA.

In one or more embodiments, one or more iterations of the configuration loop may be performed, and in some embodiments an iteration of the configuration loop (referred to herein as the "present" iteration) may comprise: for a present iteration current value of the current signal output by the analog current output, obtaining a measured voltage by performing a voltage measurement of a voltage at the output interface of the source apparatus.

In one or more embodiments, the present iteration current value may be set at each current iteration. In particular, for the first iteration of the loop, the present iteration current value (first iteration current value) may be based on (for example substantially equal to) the predefined initial current value used for initializing the configuration loop.

In one or more embodiments, an iteration of the configuration loop may comprise: performing, by the source apparatus, one or more measurements of a voltage (Vs) at the first and second output signal terminals through which the source apparatus is connected to the receptor apparatus. In some embodiments, the one or more voltage measurements may be performed further to performing a current injection in the receptor apparatus to which the source apparatus is connected. In some embodiments, the current value used for the current injection may be chosen based on (for example substantially equal to) the present iteration current value of the current signal output by the analog current output.

In one or more embodiments, a plurality of voltage measurements of the voltage (Vs) may be performed, and the obtaining a measured voltage may comprise determining a mean (Vsm) of the plurality of the voltage measurements of the voltage (Vs). Using a mean value advantageously reduces the measurement error associated with one measurement through using a mean (Vsm) instead of a single measurement. Preferably, the number of voltage measurements of the voltage (Vs) may be chosen high enough (e.g. in the order of 20) in order to reduce a measurement uncertainty below a predefined value.

Depending on the embodiment, any suitable mean formula may be used to determine the mean (Vsm) of the plurality of voltage measurements of the voltage (Vs).

In one or more embodiments, the voltage measurement(s) may be performed between a first terminal and a second terminal of the output interface of the source apparatus through which the external device is coupled to the source apparatus.

In one or more embodiments, the measured voltage (Vs) may be stored in a memory, such as for example a memory of the source apparatus. In some embodiments, the measured voltage (Vs) may be stored in a memory in association with a corresponding current value (Is) of a current injected to the receptor apparatus prior to performing the voltage measurement(s). In embodiments in which a mean voltage measurement (Vsm) is used, the mean (Vsm) of the plurality of voltage measurements of the voltage (Vs) may be stored in a memory, such as for example a memory of the source apparatus. In some embodiments, the mean voltage (Vsm) may be stored in a memory in association with a corresponding current value (Is) of a current injected to the receptor apparatus prior to performing the voltage measurement(s).

In one or more embodiments, a plurality of configuration loop iterations may be performed, and the current iteration may further comprise comparing the present iteration current value with a predefined current threshold value to determine whether the current iteration is the last iteration of the configuration loop.

For example, in some embodiments, a determination may be made as to whether or not the present iteration current value is inferior to the predefined current threshold value.

In some embodiments, based on determining that the present iteration current value is inferior to a predefined current threshold value, the present iteration current value may be incremented (for example by a predefined configuration loop current value step), and a new iteration of the configuration loop may be performed with the updated present iteration current value used as present iteration current value. Otherwise (based on determining that the present iteration current value is not inferior to a predefined current threshold value) the configuration loop may be exited.

Therefore, in some embodiments, several iterations of the configuration loop may be performed for different respective present iteration current values, and the configuration loop may be stopped based on the last updated value of the present iteration current value being greater than a predefined current threshold value.

In one or more embodiments, a self-configuration loop may be performed for executing one or more of self-configuration loop iterations, and an iteration comprising load characterization operations and output type determination operations, such as for example comprising: Obtaining one or more measured voltages respectively corresponding to one or more respective current values of a current signal injected in (output to) the receptor apparatus through the analog current output; and performing a determination of a type of an analog electrical output signal to be output by the output interface, based on the one or more measured voltages. Performing a plurality of iterations of the self-configuration loop may advantageously allow determining a type of output according to which the source apparatus is to be configured in a case where one or more iterations leads to an indetermination result as to the type of output according to which the source apparatus is to be configured.

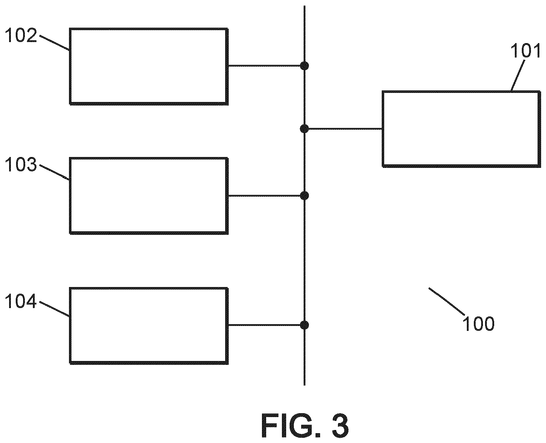

Figure 3 illustrates a source apparatus 100 configured to use features in accordance with embodiments of the present subject disclosure.

The source apparatus 100 may include a control engine 101, a configuration engine 102, an output interface engine 103, a memory 104, and a power supply (e.g., a battery, plug-in power supply, etc.) (not represented on the figure). The source apparatus 100 may be configured with a electrical signal interface (not represented on the figure) configured for electrically coupling the source apparatus to a receptor apparatus (through an output interface comprising a first and second output signal terminals of the source apparatus) for receiving an analog electrical input signal through the coupling interface (not represented on the figure).

In the architecture illustrated on Fig. 3, all of the configuration engine 102, output interface engine 103, and memory 104 are operatively coupled with one another through the control engine 101.

In one or more embodiments, the configuration engine 102 is configured to perform various aspects of embodiments of the proposed methods for configuring a source apparatus as described herein. For example, in some embodiments, the configuration engine 102 may be configured for configuring an output interface of the source apparatus to be an analog current output, for obtaining one or more measured voltages respectively corresponding to one or more respective current values of a current signal injected in (output to) the receptor apparatus through the analog current output, and for performing a determination of a type of an analog electrical output signal to be output by the analog current output, based on the one or more measured voltages. In some embodiments, the configuration engine 102 may be further configured for configuring the output interface of the source apparatus based on the determination of the type of the analog electrical output signal to be output by the analog current output.

In one or more embodiments, the output interface engine 103 is configured to manage an electrical signal interface with the receptor apparatus in situations where the source apparatus 100 is coupled to a receptor apparatus. For example, in some embodiments, the output interface engine 103 may be configured for one or more of performing a current injection to the receptor apparatus of a current value corresponding to a present iteration current value, and obtaining a measured voltage by performing a voltage measurement of a voltage at the output interface (in some embodiments at the first and second output signal terminals) of the source apparatus.

The control engine 101 includes a processor, which may be any suitable microprocessor, microcontroller, Field Programmable Gate Arrays (FPGA), Application Specific Integrated Circuits (ASIC), Digital Signal Processing chip, and/or state machine, or a combination thereof. According to various embodiments, one or more of the computers can be configured as a multi-processor computer having multiple processors for providing parallel computing. The control engine 101 may also comprise, or may be in communication with, computer storage media, such as, without limitation, the memory 104, capable of storing computer program instructions or software code that, when executed by the processor, causes the processor to perform the elements described herein. In addition, the memory 104 may be any type of data storage computer storage medium, capable of storing a data structure representing a computer network to which the source apparatus 100 belongs, coupled to the control engine 101 and operable with the output interface engine 103 and the configuration engine 102 to facilitate management and processing of data stored in association therewith.

In embodiments of the present subject disclosure, the source apparatus 100 is configured for performing the methods described herein.

It will be appreciated that the source apparatus 100 shown and described with reference to Fig. 3 is provided by way of example only. Numerous other architectures, operating environments, and configurations are possible. Other embodiments of the source apparatus may include fewer or greater number of components and may incorporate some or all of the functionality described with respect to the source apparatus components shown in Fig. 3. Accordingly, although the control engine 101, configuration engine 102, output interface engine 103, and memory 104 are illustrated as part of the source apparatus 100, no restrictions are placed on the location and control of components 102 - 104. In particular, in other embodiments, components 102 - 104 may be part of different entities or computing systems.

Depending on the embodiment, the apparatus 100, and one or more of the engines (components) comprised therein, may be implemented in software, as described above, or in hardware, such as an application specific integrated circuit (ASIC), or in the form of a combination of hardware and software, such as for example a software program intended to be loaded and executed on a component of FPGA (Field Programmable Gate Array) type.

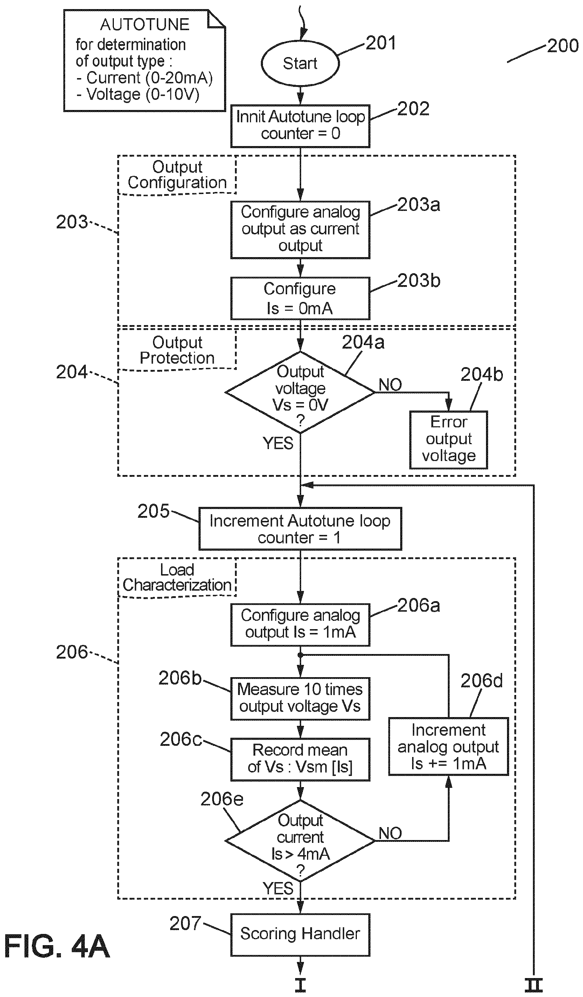

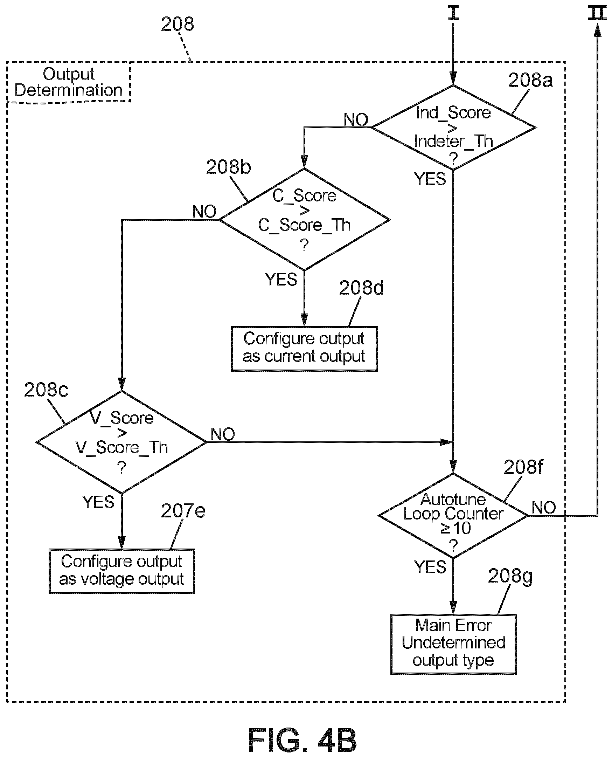

Figures 4A and 4B shows a diagram illustrating a method for self-configuring a source apparatus according to one or more embodiments of the present subject disclosure.

The proposed method (200) illustrated on Figs. 4A and 4B corresponds to the exemplary context of a self-configuring of a source apparatus configured to use (comply with) some of the specifications of the standard specification IEC 61131-2. In particular, specific values used in the following description of Figs. 4A and 4B are exemplary numerical values that may in some embodiments be chosen for a source apparatus configured to use (comply with) some of the specifications of the standard specification IEC 61131-2.

For example, in one or more embodiments, specific numerical values used in the proposed "autotune" method for a source apparatus configured to use (comply with) some of the specifications of the standard specification IEC 61131-2 may correspond to an electrical input signal of the voltage input signal type having a voltage value between 0 V and 10 V, and to an electrical input signal of the current input signal type having a current value between 0 V and 20 mA.

The proposed scheme may start (201) with initializing (202) a counter of an auto-configuration (which may be referred to herein as "autotune") loop (e.g. to the value 0) prior to starting a first iteration of the auto-configuration loop.

Initializing the auto-configuration loop may be performed to start a new iteration of the auto-configuration loop, which may be referred to as the "present auto-configuration loop iteration", which may comprise one or more of the operations shown on Fig. 4A and Fig. 4B and described in the following.

In one or more embodiments, prior to starting a new iteration of the auto-configuration loop, the output interface of the source apparatus may be configured (203). In some embodiments, configuring the output interface of the source apparatus may comprise configuring (202a) the analog interface of the source apparatus as an analog current output. In some embodiments, configuring the output interface of the source apparatus as an analog current output may comprise configuring the (analog) output impedance of the source apparatus as a low (resistive) impedance, e.g. through an output resistor having a resistive value lower than 10 kOhms. In some embodiments, configuring the output interface of the source apparatus as an analog current output may comprise connecting the output interface to a current generator (a current source) of the source apparatus. In some embodiments, once the analog interface of the source apparatus is configured to operate as an analog current output, the configuring the output interface of the source apparatus may further comprise configuring (202b) the output interface to output a current signal of a current value predefined to be an output protection current value, which in some embodiments may be chosen substantially equal to 0 mA.

The configuring the output interface of the source apparatus as an analog current output that outputs a current signal of a weak current value may advantageously be performed in order to proceed with operations for protecting the output. In some embodiments, operations for output protection (204) may be performed, which may comprise performing a voltage measurement of a voltage (Vs) at the output interface of the source apparatus (for example in some embodiments at first and second output signal terminals of the source apparatus). In some embodiments, the operations for output protection (204) may comprise testing (204a) the (measured) output voltage Vs (corresponding to a substantially null current output to the receptor apparatus) to determine whether or not its value is substantially equal to 0 V. In some embodiments, in case the (measured) output voltage Vs is substantially equal to 0 V (for a substantially null current being output to the receptor apparatus), the output protection operations may be considered complete, and the proposed method may proceed to starting a first iteration of the auto-configuration loop. In some embodiments, in case the (measured) output voltage Vs is not substantially equal to 0 V (for a substantially null current being output to the receptor apparatus), an error may be triggered (204b). For example, it may be determined, based on a non-null value of the output voltage Vs corresponding to an output current of a null value being fed to the receptor apparatus, that an unexpected use of the source apparatus is occurring, so that a system error may be triggered.

In one or more embodiments, the proposed scheme may proceed with incrementing (205) a counter of the auto-configuration loop (e.g. by 1) as part of starting a new iteration of the auto-configuration loop.

Incrementing the auto-configuration loop counter may be performed to start a new present auto-configuration loop iteration, which may comprise one or more of the operations shown on Fig. 4A and Fig. 4B and described in the following.

In one or more embodiments, operations of the present auto-configuration loop iteration may comprise performing load characterization (206) operations.

In some embodiments, the load characterization (206) operations may comprise performing a configuration loop, which may be referred to herein as a load characterization loop.

In some embodiments, operations (206) of the load characterization loop may comprise configuring (206a) the analog current output of the source apparatus to output (to the receptor apparatus) a current signal of a predefined initial current value. The configuration of the analog current output to output a current signal of a predefined initial current value (*Init - Cur - Value*) may be performed to initialize the load characterization loop with respect to a current signal of a respective current value injected to the receptor apparatus for each iteration of the load characterization loop.

In some embodiments, the initial current value may be predefined to be substantially equal to 1 mA, and a present iteration current value ( *Present - Iteration - Cur - Value*) used during a present iteration may be initialized to 1 mA (*Present - Iteration - Cur - Value = Init - Cur - Value = 1 mA*)*.*

In some embodiments, operations (206) of the load characterization loop may further comprise: Performing one or more iterations of the load characterization loop, a (present) iteration of the load characterization loop comprising: for the present iteration current value of the current signal output (to the receptor apparatus) by the analog current output, performing a current injection to the receptor apparatus of a current value corresponding to the present iteration current value. In some embodiments, the (present) iteration of the load characterization loop may further comprise: obtaining a measured voltage by performing (206b) a voltage measurement of a voltage at the output interface of the source apparatus. The measured voltage may respectively correspond to the respective current value of the current (the present iteration current value) injected to the receptor apparatus through the output interface.

In one or more embodiments, operations (206) of a (present) iteration of the load characterization loop may comprise measuring (206b) an output voltage (Vs) at the output interface (for example at first and second output signal terminals of the source apparatus) of the source apparatus coupled to the receptor apparatus. In some embodiments, the output voltage measurement may be performed at the output interface with respect to (in connection to) a current injection to the receptor apparatus of a current signal of a present iteration current value. For example, depending on the embodiment, the output voltage measurement may be performed at the output interface while a current signal of a present iteration current value is being injected into the receptor apparatus, or further to injecting a current signal of a present iteration current value into the receptor apparatus. In one or more embodiments, the output voltage measured during a present iteration of the load characterization loop may therefore result from a voltage measurement performed for a current signal of a present iteration current value injected to the receptor apparatus through the output interface of the source apparatus, and may therefore respectively correspond to the present iteration current value.

In some embodiments, the measuring (206b) the voltage (Vs) at the output interface may be performed several times (e.g. 10 times), so that a plurality of voltage measurements (Vs) may be obtained. In some embodiments, a mean voltage value (Vsm) may be determined based on the plurality of voltage measurements (Vs) and stored (206c) in memory (of the source apparatus). An iteration of the load characterization loop may therefore result in some embodiments in a mean voltage value (Vsm) corresponding to a mean of a plurality of voltage measurements (Vs) of voltage at the output interface coupled to the receptor apparatus, the voltage measurements (Vs) of voltage being performed for a current signal of a present iteration current value injected to the receptor apparatus through the output interface of the source apparatus. As a consequence, in some embodiments the mean voltage value (Vsm) (corresponding to a mean of the plurality of voltage measurements (Vs) of voltage) may respectively correspond to the present iteration current value of a current signal (Is) injected to the receptor apparatus through the output interface.

In one or more embodiments, operations (206) of a (present) iteration of the load characterization loop may comprise comparing (206e) the present iteration current value with a predefined threshold to determine whether or not a further iteration of the load characterization loop should be performed. In some embodiments, in case the present iteration current value is greater or equal to the predefined threshold, the load characterization loop may be stopped (no further iteration of the loop may be performed), and the proposed method may proceed with processing (207) the measured voltage values. In some embodiments, in case the present iteration current value is not greater or equal to the predefined threshold, the present iteration current value (which may serve as a load characterization loop counter) may be incremented (206d), and a new present iteration of the load characterization loop may be started, as described above.

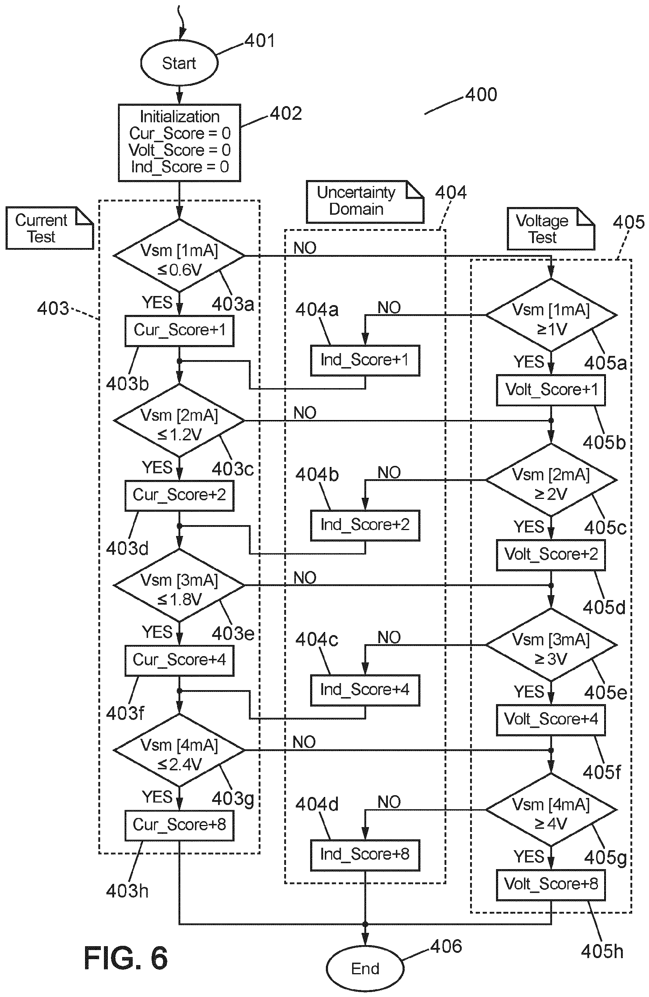

In one or more embodiments, once the load characterization operations (206) are complete, a processing of the results of the load characterization operations is performed (207), which in some embodiments may comprise "scoring handler" operations, an example of which is described in relation with Fig. 6.

In some embodiments, the scoring handler operations (207) may produce one or more scores, which may comprise one or more of an undetermined output score (*U_Score*)*,* a current score (*C_Score*)*,* and a voltage score (*V_Score*)*.* In some embodiments, the U_Score may be used to measure a level of indetermination associated with the type of analog output that is to be used for configuring the analog output of the source device in cases for purposes of feeding an electrical output signal to the receptor apparatus. In some embodiments, the V_Score may be used to measure a level of certainty associated with the type of analog output that is to be used for configuring the analog output of the source device (for purposes of feeding an electrical output signal to the receptor apparatus) being determined as being a voltage output. In some embodiments, the C_Score may be used to measure a level of certainty associated with the type of analog output that is to be used for configuring the analog output of the source device (for purposes of feeding an electrical output signal to the receptor apparatus) being determined as being a current output.

In one or more embodiments, an iteration of the self-configuration loop may proceed with operations for output determination (208) based on the one or more scores produced by the scoring handler operations (207).

In one or more embodiments, the output determination operations (208) may comprise testing one or more of an undetermined output score, a current score, and a voltage score produced by the scoring handler operations (207).

For example, as shown on Fig. 4b, in some embodiments, a test of the undetermined output score may be performed (208a) to determine whether or not the undetermined output score is higher than a predefined undetermined output threshold. In some embodiments, in cases where it is determined that the undetermined output score is higher than the predefined undetermined output threshold, the proposed method may proceed to determine (208f) whether a new iteration of the self-configuration loop is to be performed.

In some embodiments, in cases where it is determined that the undetermined output score is not higher than the predefined undetermined output threshold, a test of the current score may be performed (208b) to determine whether or not the current score is higher than a predefined current threshold. In some embodiments, in cases where it is determined that the current score is higher than the predefined current threshold, the analog output of the source apparatus may be configured (208d) as a current output. For example, according to the IEC 61131-2 standard specification, the analog output may be configured to deliver a current signal between 0 mA and 20 mA.

In some embodiments, in cases where it is determined that the current score is not higher than the predefined current threshold, a test of the voltage score may be performed (208c) to determine whether or not the voltage score is higher than a predefined voltage threshold. In some embodiments, in cases where it is determined that the voltage score is higher than the predefined voltage threshold, the analog output of the source apparatus may be configured (208e) as a voltage output. For example, according to the IEC 61131-2 standard specification, the analog output may be configured to deliver a voltage signal between 0V and 10V.

In some embodiments, in cases where it is determined that the voltage score is not higher than the predefined voltage threshold, the proposed method may proceed to determine (208f) whether a new iteration of the self-configuration loop is to be performed.

In some embodiments, the determining (208f) as to whether a new iteration of the self-configuration loop is to be performed may comprise comparing the self-configuration loop counter with a predefined self-configuration loop threshold (e.g. to be equal to 10). In some embodiments, in cases where the self-configuration loop counter is higher than the predefined self-configuration loop threshold, an error status may be triggered (208g), and the proposed determination may result in the error.

In some embodiments, in cases where the self-configuration loop counter is not higher than the predefined self-configuration loop threshold, a new iteration of the self-configuration loop may be started, for example with the incrementing (205) of the self-configuration loop counter as described above.

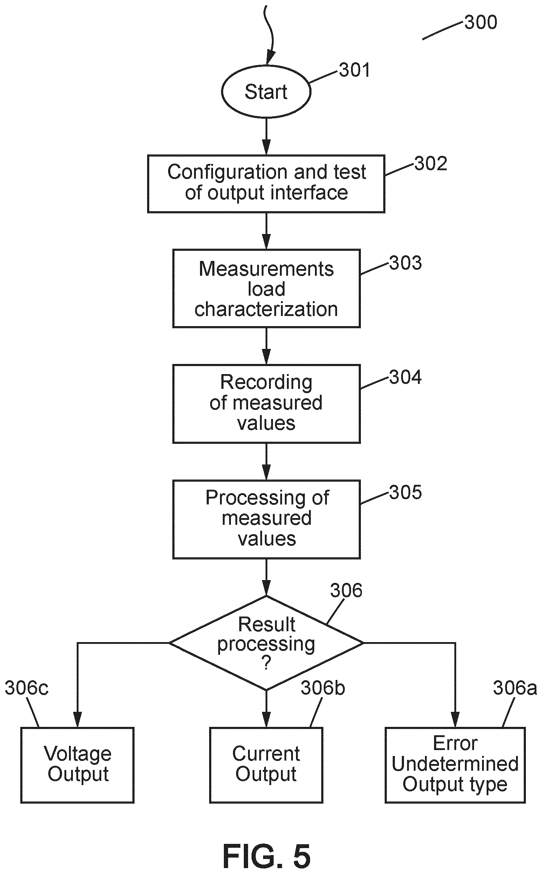

Fig. 5 shows a diagram illustrating a method (300) for self-configuring a source apparatus according to one or more embodiments of the present subject disclosure.

In one or more embodiments, the proposed scheme may start (301) with configuring (and in some embodiments testing) (302) the output interface of the source apparatus as an analog voltage output or as an analog current output.

In some embodiments, the output interface of the source apparatus may be first configured as an analog current output. The configuring of the output interface of the receptor apparatus as an analog current output may advantageously be performed before performing a load characterization to determine whether or not there is a system error by measuring a voltage at the output interface of the source apparatus further to injecting a substantially null current signal to the receptor apparatus, and determining whether or not the measured voltage is also substantially null. In some embodiments, in case where the voltage measured at the output interface is not substantially null for a substantially null current fed to the receptor apparatus, a system error may be detected, and the load characterization operations may be aborted.

In one or more embodiments, one or more load characterization operations (303) may be performed, which may comprise measuring one or more voltage values (Vs) of voltage at the output interface coupled to the receptor apparatus for one or more values of current (Is) injected by the source apparatus to the receptor apparatus through the output interface. In some embodiments, the measuring of the voltage at the output interface may be performed several times for respective values of current injected by the source apparatus to the receptor apparatus, so that a plurality of voltage measurements Vs[Is] may be obtained. In some embodiments, one or more respective mean voltage values (Vsm) of a plurality of voltage values (Vs) of voltage at the output interface coupled to the receptor apparatus, the mean voltage values being respectively associated to a respective current value (Is) of current injected to the receptor apparatus, may be determined. In some embodiments, the mean voltage values (Vsm[Is]) may be respectively associated to respective current values (Is) injected by the source apparatus to the receptor apparatus through the output interface.

In one or more embodiments, once one or more measured voltage values have been obtained further to performing voltage measurements for load characterization (303), the one or more measured voltage values may be stored (304) in a memory.

In one or more embodiments, a processing (305) of the one or more measured voltage values may be performed based on the one or more measured voltage values stored (304) in memory. In some embodiments, the processing of measured voltage values obtained for load characterization may comprise one or more of the operations described in relation with Figs. 4a and 4b, and Fig. 6.

In one or more embodiments, the processing (305) of the one or more measured voltage values may lead (306) to one of the following processing results:
As a first possible result in some embodiments, the processing (305) of the one or more measured voltage values may lead (306) to the determination that the output interface of the source apparatus is to be configured (306c) as a voltage output for operating with the receptor apparatus coupled to the source apparatus.

As a second possible result in some embodiments, the processing (305) of the one or more measured voltage values may lead (306) to the determination that the output interface of the source apparatus is to be configured (306b) as a current output for operating with the receptor apparatus coupled to the source apparatus.

As a third possible result in some embodiments, the processing (305) of the one or more measured voltage values may lead (306a) to the finding that it cannot be determined, based on the processing (305) of the one or more measured voltage values, whether the output interface of the source apparatus is to be configured as a current output or as a voltage output for operating with the receptor apparatus coupled to the source apparatus. In such case, an error may be declared in some embodiments and signaled to user through any suitable user interface of the source apparatus (e.g. a blinking light, a graphical user interface etc.).

Fig. 6 shows a diagram illustrating a method (400) for self-configuring a source apparatus according to one or more embodiments of the present subject disclosure.

More specifically, Fig. 6 illustrates a scheme for processing data generated by a load characterization procedure (206) (303 - 304) according to embodiments of the present subject disclosure, such as for example described in relation with Figs. 5a/5b and 4.

In one or more embodiments, the proposed scheme may start (401) with initializing (402) one or more scores, such as for example such as an undetermined output score, a voltage score, and a current score. In some embodiments, each of the scores determined as part of the data processing may be initialized to respective predefined initialization values. For example, in some embodiments in which a voltage score is used, the voltage score may be initialized to a predefined voltage score initialization value (e.g. 0). For example, in some embodiments in which a current score is used, the current score may be initialized to a predefined current score initialization value (e.g. 0). For example, in some embodiments in which a voltage score is used, the voltage score may be initialized to a predefined voltage score initialization value (e.g. 0). For example, in some embodiments in which an undetermined output score is used, the undetermined output score may be initialized to a predefined undetermined output score initialization value (e.g. 0).

Fig. 6 shows an exemplary scheme that illustrates embodiments of the present subject disclosure in which a current score, a voltage score and an undetermined output score are used. For example, as shown in Fig. 6, in some embodiments the current score, voltage score and undetermined output score may be used for performing a current test (403), a voltage test (404), and an undetermined output test (405), respectively.

In one or more embodiments, one or more tests (403, 405) may be performed on representative voltage values respectively corresponding to current values of a current signal injected to the receptor apparatus for purposes of performing one or more respective voltage measurements. In some embodiments, one or more (in some embodiments each) of the representative voltage values may be determined based on the corresponding one or more respective voltage measurements performed further to injecting to the receptor apparatus the current signal of the corresponding current value.

In one or more embodiments, the current values of injected current signal used for performing the one or more tests may respectively correspond to iteration current values used in iterations of a load characterization loop configured for obtaining respective representative voltage values, such as for example the exemplary load characterization loop (206a - 206e) illustrated on Fig. 5a and 5b. Referring to this example, and as illustrated by Fig. 6, one or more tests may be performed for each of the iterations of the load characterization loop configured for obtaining representative voltage values respectively corresponding to present iteration current values (in the example of Figs. 5a and 5b, the present iteration current values are 1 mA, 2 mA, 3 mA, and 4 mA).

In one or more embodiments, a first current test and a first voltage test may be performed on a first representative voltage value for a first current value (in some embodiments corresponding to the current value injected to the receptor apparatus during performance of the first iteration of the load characterization loop), which in some embodiments may correspond to a first iteration current value used in a first iteration of a load characterization loop configured for obtaining the first representative voltage value. In some embodiments, the first representative voltage value may correspond to one or more voltages measured at the output interface for the corresponding first current value of a current signal injected to the receptor apparatus. In some embodiments, the representative voltage value may be a mean (Vsm[Is]) of a plurality of voltages measured at the output interface for the corresponding current signal of the first current value injected to the receptor apparatus.

For example, in embodiments in which the source apparatus is configured to follow (or comply with) specifications of the IEC 61131-2 standard specification, the first current value of the current signal injected to the receptor apparatus may be chosen to be equal to Is = 1 mA.

In some embodiments, the first current test may comprise comparing (403a) the first representative voltage value with a predefined first current test voltage threshold. For example, in embodiments in which the source apparatus is configured to follow (or comply with) specifications of the IEC 61131-2 standard specification, the predefined first current test voltage threshold value may be chosen to be equal to 0.6V.

In some embodiments, in cases where the representative voltage value is smaller than the predefined first current test voltage threshold, the current score may be incremented by a predefined first current score increment value. In some embodiments, the first current score increment value may be defined based on the first current value (for example through a linear transform). For example, in some embodiments in which the first current value is equal to Is = 1 mA, the first current score increment value may be chosen equal to 1, so as to correspond to a weight commensurate with the load characterization results obtained for the first current value.

In some embodiments, in cases where the representative voltage value is not smaller than the predefined first current test voltage threshold, an operation (405a) of the voltage test (405) may be performed.

In some embodiments, the voltage test (405) may comprise comparing (405a) the first representative voltage value with a predefined first voltage test voltage threshold. In some embodiments in which the source apparatus is configured to follow (or comply with) specifications of the IEC 61131-2 standard specification, the predefined first voltage test voltage threshold value may be chosen to be equal to 1 V.

In some embodiments, in cases where the representative voltage value is greater than the predefined first voltage test voltage threshold, the voltage score may be incremented by a predefined first voltage score increment value. In some embodiments, the first voltage score increment value may be defined based on the first current value (for example through a linear transform). For example, in some embodiments in which the first current value is equal to Is = 1 mA, the first voltage score increment value may be chosen equal to 1, so as to correspond to a weight commensurate with the load characterization results obtained for the first current value.

In some embodiments, in cases where the representative voltage value is not greater than the predefined first current test voltage threshold, an operation (404a) of a undetermined output test (which may be also referred to herein as an "uncertainty domain" test) (404) may be performed. The operation (404a) of the undetermined output test may comprise incrementing an undetermined output score by a predefined first undetermined output score increment value. In some embodiments, the first undetermined output score increment value may be defined based on the first current value (for example through a linear transform). For example, in some embodiments in which the first current value is equal to Is = 1 mA, the first undetermined output score increment value may be chosen equal to 1, so as to correspond to a weight commensurate with the load characterization results obtained for the first current value.

In one or more embodiments, a second current test and a second voltage test may be performed on a second representative voltage value for a second current value (in some embodiments corresponding to the current value injected to the receptor apparatus during performance of the second iteration of the load characterization loop), which in some embodiments may correspond to a second iteration current value used in a second iteration of a load characterization loop configured for obtaining the second representative voltage value. In some embodiments, the second representative voltage value may correspond to one or more voltages measured at the output interface for the corresponding second current value of a current signal injected to the receptor apparatus. In some embodiments, the representative voltage value may be a mean (Vsm[ls]) of a plurality of voltages measured at the output interface for the corresponding current signal of the second current value injected to the receptor apparatus.

For example, in embodiments in which the source apparatus is configured to follow (or comply with) specifications of the IEC 61131-2 standard specification, the second current value of the current signal injected to the receptor apparatus may be chosen to be equal to Is = 2 mA.

In some embodiments, the second current test may comprise comparing (403c) the second representative voltage value with a predefined second current test voltage threshold. For example, in embodiments in which the source apparatus is configured to follow (or comply with) specifications of the IEC 61131-2 standard specification, the predefined second current test voltage threshold value may be chosen to be equal to 1.2 V.

In some embodiments, in cases where the representative voltage value is smaller than the predefined second current test voltage threshold, the current score may be incremented by a predefined second current score increment value. In some embodiments, the second current score increment value may be defined based on the second current value (for example through a linear transform). For example, in some embodiments in which the second current value is equal to Is = 2 mA, the second current score increment value may be chosen equal to 2, so as to correspond to a weight commensurate with the load characterization results obtained for the second current value.

In some embodiments, in cases where the representative voltage value is not smaller than the predefined second current test voltage threshold, an operation (405c) of the voltage test (405) may be performed.

In some embodiments, the voltage test (405) may comprise comparing (405c) the second representative voltage value with a predefined second voltage test voltage threshold. In some embodiments in which the source apparatus is configured to follow (or comply with) specifications of the IEC 61131-2 standard specification, the predefined second voltage test voltage threshold value may be chosen to be equal to 2 V.

In some embodiments, in cases where the representative voltage value is greater than the predefined second voltage test voltage threshold, the voltage score may be incremented by a predefined second voltage score increment value. In some embodiments, the second voltage score increment value may be defined based on the second current value (for example through a linear transform). For example, in some embodiments in which the second current value is equal to Is = 2 mA, the second voltage score increment value may be chosen equal to 2, so as to correspond to a weight commensurate with the load characterization results obtained for the second current value.

In some embodiments, in cases where the representative voltage value is not greater than the predefined second current test voltage threshold, an operation (404b) of the undetermined output test (404) may be performed. The operation (404b) of the undetermined output test may comprise incrementing an undetermined output score by a predefined second undetermined output score increment value. In some embodiments, the second undetermined output score increment value may be defined based on the second current value (for example through a linear transform). For example, in some embodiments in which the second current value is equal to Is = 2 mA, the second undetermined output score increment value may be chosen equal to 2, so as to correspond to a weight commensurate with the load characterization results obtained for the second current value.

In one or more embodiments, a third current test and a third voltage test may be performed on a third representative voltage value for a third current value (in some embodiments corresponding to the current value injected to the receptor apparatus during performance of the third iteration of the load characterization loop), which in some embodiments may correspond to a third iteration current value used in a third iteration of a load characterization loop configured for obtaining the third representative voltage value. In some embodiments, the third representative voltage value may correspond to one or more voltages measured at the output interface for the corresponding third current value of a current signal injected to the receptor apparatus. In some embodiments, the representative voltage value may be a mean (Vsm[ls]) of a plurality of voltages measured at the output interface for the corresponding current signal of the third current value injected to the receptor apparatus.

For example, in embodiments in which the source apparatus is configured to follow (or comply with) specifications of the IEC 61131-2 standard specification, the third current value of the current signal injected to the receptor apparatus may be chosen to be equal to Is = 3 mA.

In some embodiments, the third current test may comprise comparing (403e) the third representative voltage value with a predefined third current test voltage threshold. For example, in embodiments in which the source apparatus is configured to follow (or comply with) specifications of the IEC 61131-2 standard specification, the predefined third current test voltage threshold value may be chosen to be equal to 1.8 V.

In some embodiments, in cases where the representative voltage value is smaller than the predefined third current test voltage threshold, the current score may be incremented by a predefined third current score increment value. In some embodiments, the third current score increment value may be defined based on the third current value (for example through a linear transform). For example, in some embodiments in which the third current value is equal to Is = 3 mA, the third current score increment value may be chosen equal to 4, so as to correspond to a weight commensurate with the load characterization results obtained for the third current value.

In some embodiments, in cases where the representative voltage value is not smaller than the predefined third current test voltage threshold, an operation (405e) of the voltage test (405) may be performed.

In some embodiments, the voltage test (405) may comprise comparing (405e) the third representative voltage value with a predefined third voltage test voltage threshold. In some embodiments in which the source apparatus is configured to follow (or comply with) specifications of the IEC 61131-2 standard specification, the predefined third voltage test voltage threshold value may be chosen to be equal to 3 V.

In some embodiments, in cases where the representative voltage value is greater than the predefined third voltage test voltage threshold, the voltage score may be incremented by a predefined third voltage score increment value. In some embodiments, the third voltage score increment value may be defined based on the third current value (for example through a linear transform). For example, in some embodiments in which the third current value is equal to Is = 3 mA, the third voltage score increment value may be chosen equal to 4, so as to correspond to a weight commensurate with the load characterization results obtained for the third current value.

In some embodiments, in cases where the representative voltage value is not greater than the predefined third current test voltage threshold, an operation (404c) of the undetermined output test (404) may be performed. The operation (404c) of the undetermined output test may comprise incrementing an undetermined output score by a predefined third undetermined output score increment value. In some embodiments, the third undetermined output score increment value may be defined based on the third current value (for example through a linear transform). For example, in some embodiments in which the third current value is equal to Is = 3 mA, the third undetermined output score increment value may be chosen equal to 4, so as to correspond to a weight commensurate with the load characterization results obtained for the third current value.

In one or more embodiments, a fourth current test and a fourth voltage test may be performed on a fourth representative voltage value for a fourth current value (in some embodiments corresponding to the current value injected to the receptor apparatus during performance of the fourth (and last) iteration of the load characterization loop), which in some embodiments may correspond to a fourth iteration current value used in a fourth iteration of a load characterization loop configured for obtaining the fourth representative voltage value. In some embodiments, the fourth representative voltage value may correspond to one or more voltages measured at the output interface for the corresponding fourth current value of a current signal injected to the receptor apparatus. In some embodiments, the representative voltage value may be a mean (Vsm[Is]) of a plurality of voltages measured at the output interface for the corresponding current signal of the fourth current value injected to the receptor apparatus.

For example, in embodiments in which the source apparatus is configured to follow (or comply with) specifications of the IEC 61131-2 standard specification, the fourth current value of the current signal injected to the receptor apparatus may be chosen to be equal to Is = 4 mA.

In some embodiments, the fourth current test may comprise comparing (403e) the fourth representative voltage value with a predefined fourth current test voltage threshold. For example, in embodiments in which the source apparatus is configured to follow (or comply with) specifications of the IEC 61131-2 standard specification, the predefined fourth current test voltage threshold value may be chosen to be equal to 2.4 V.

In some embodiments, in cases where the representative voltage value is smaller than the predefined fourth current test voltage threshold, the current score may be incremented by a predefined fourth current score increment value. In some embodiments, the fourth current score increment value may be defined based on the fourth current value (for example through a linear transform). For example, in some embodiments in which the fourth current value is equal to Is = 4 mA, the fourth current score increment value may be chosen equal to 8, so as to correspond to a weight commensurate with the load characterization results obtained for the fourth current value.

In some embodiments, in cases where the representative voltage value is not smaller than the predefined fourth current test voltage threshold, an operation (405e) of the voltage test (405) may be performed.

In some embodiments, the voltage test (405) may comprise comparing (405e) the fourth representative voltage value with a predefined fourth voltage test voltage threshold. In some embodiments in which the source apparatus is configured to follow (or comply with) specifications of the IEC 61131-2 standard specification, the predefined fourth voltage test voltage threshold value may be chosen to be equal to 4 V.

In some embodiments, in cases where the representative voltage value is greater than the predefined fourth voltage test voltage threshold, the voltage score may be incremented by a predefined fourth voltage score increment value. In some embodiments, the fourth voltage score increment value may be defined based on the fourth current value (for example through a linear transform). For example, in some embodiments in which the fourth current value is equal to Is = 4 mA, the fourth voltage score increment value may be chosen equal to 8, so as to correspond to a weight commensurate with the load characterization results obtained for the fourth current value.

In some embodiments, in cases where the representative voltage value is not greater than the predefined fourth current test voltage threshold, an operation (404c) of the undetermined output test (404) may be performed. The operation (404c) of the undetermined output test may comprise incrementing an undetermined output score by a predefined fourth undetermined output score increment value. In some embodiments, the fourth undetermined output score increment value may be defined based on the fourth current value (for example through a linear transform). For example, in some embodiments in which the fourth current value is equal to Is = 4 mA, the fourth undetermined output score increment value may be chosen equal to 8, so as to correspond to a weight commensurate with the load characterization results obtained for the fourth current value.

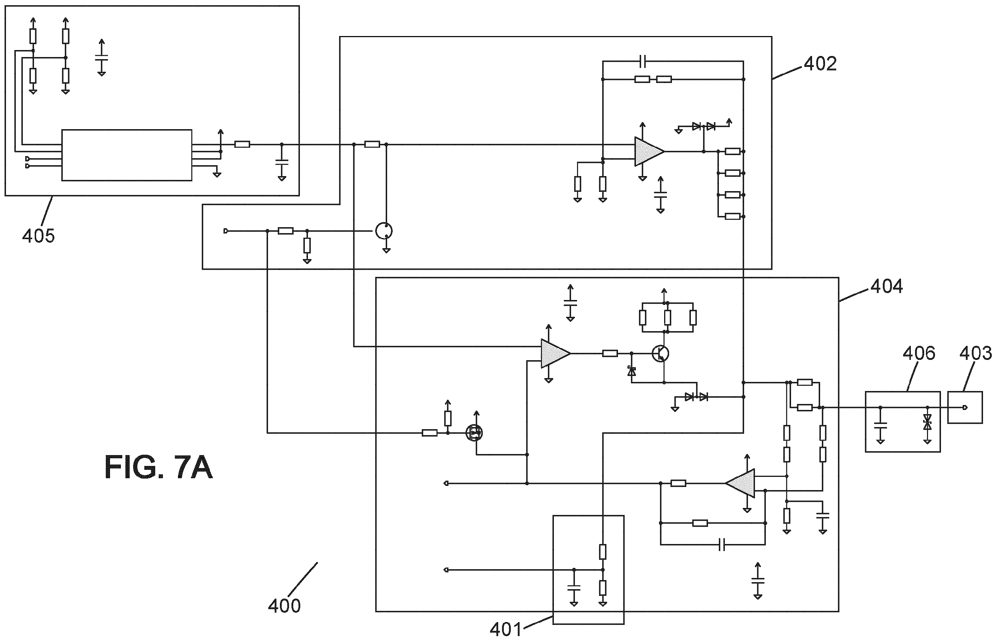

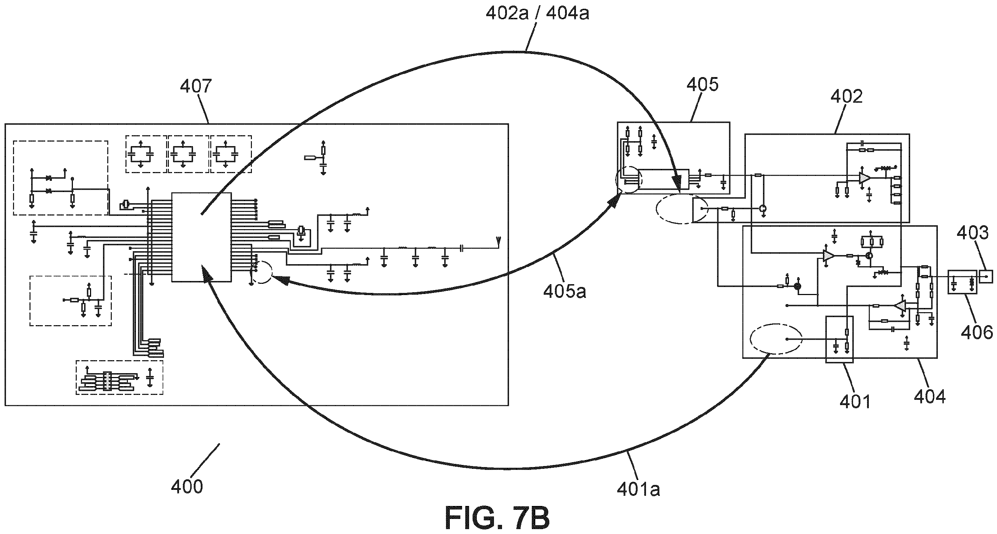

Figures 7a and 7b illustrate a source apparatus 400 configured to use features in accordance with embodiments of the present subject disclosure.

In one or more embodiments, the source apparatus 400 may include a output voltage/current measurement module 401, an output adapter (for voltage output) 402, one or more output connectors 403, and output adapter (for current output) 404, and Digital to Analog converter (DAC) 405, a protection module 406, a Microcontroller Unit (MCU) 407, and a power supply (e.g., a battery, plug-in power supply, etc.) (not represented on the figure).

In the architecture illustrated on Figs. 7a and 7b, all of the output voltage/current measurement module 401, input adapter (for voltage output) 402, one or more output connectors 403, input adapter (for current output) 404, Digital to Analog converter (DAC) 405, and protection module 406 are operatively coupled with one another through the Microcontroller Unit (MCU) 407.

In one or more embodiments, the output voltage/current measurement module 401 is configured to perform various aspects of embodiments of the proposed methods for configuring a source apparatus as described herein, such as performing one or more voltage measurements of a voltage at the output interface of the source apparatus (e.g. at first and second output signal terminals of the source apparatus).

In one or more embodiments, the output adapter (for voltage output) 402 may be configured to perform various aspects of embodiments of the proposed methods for configuring a source apparatus as described herein, such as configuring the output interface of the source apparatus as a voltage output. In some embodiments, the output adapter (for voltage output) 402 may comprise an output impedance system for configuring the output interface of the source apparatus as a voltage output which delivers to the receptor apparatus an output voltage signal through the output connectors 403. In some embodiments, the output adapter (for voltage output) 402 may be configured to produce an output voltage signal to be delivered to the receptor apparatus through the output connectors 403. In some embodiments, producing the output voltage signal may comprise signal amplification and shaping to produce a voltage signal (for example, according to the IEC 61131-2 standard specification, a voltage signal between 0 V and 10 V).

In one or more embodiments, the output adapter (for current output) 404 may be configured to perform various aspects of embodiments of the proposed methods for configuring a source apparatus as described herein, such as configuring the output interface of the source apparatus as a current output. In some embodiments, the output adapter (for current output) 404 may comprise an output impedance system for configuring the output interface of the source apparatus as a current output which delivers to the receptor apparatus an output current signal through the output connectors 403. In some embodiments, the output adapter (for current output) 404 may be configured to produce an output current signal to be delivered to the receptor apparatus through the output interface. In some embodiments, producing the output current signal may comprise signal amplification and shaping to produce a current signal (for example, according to the IEC 61131-2 standard specification, a current signal between 0 mA and 20 mA).

In one or more embodiments, the protection module 406 may be configured to perform various aspects of embodiments of the proposed methods for configuring a source apparatus as described herein, such as filtering the output signals output by the output interface of the source apparatus 400 configuring the output interface of the source apparatus as a current output. In some embodiments, the protection module 406 may comprise filtering components (e.g. a filtering circuitry) for filtering the output signals output by the output interface of the source apparatus 400.

As shown on Fig. 7b, the MCU 407 may in some embodiments be configured to receive 401a (through one of its digital pin) output voltage/current data generated by the output voltage/current measurement module 401. For example, the MCU 407 may in some embodiments be configured for supervising (managing) data (voltage and/or current) stored in an output buffer (that may be used for storing output voltage and/or current measurements) through a data link 401a with the output voltage/current measurement module 401. In some embodiments, the MCU 407 may be configured to drive 402a/404a (through one of its digital pin) one or more of the input adapters 402 and 404, so that the MCU 407 may drive the analog input of the source apparatus 400 in voltage mode (analog voltage output) or in current mode (analog current output). In some embodiments, the MCU 407 may be coupled with the DAC 405 through a serial link 405a in order to generate analog output signals converted by the DAC 405 (for example through one or more output buffers of the source apparatus, for example to send one or more analog setpoints to the one or more output buffers).

In embodiments of the present subject disclosure, the source apparatus 400 is configured for performing the methods described herein.

It will be appreciated that the source apparatus 400 shown and described with reference to Figs. 7a and 7b is provided by way of example only. Numerous other architectures, operating environments, and configurations are possible. Other embodiments of the source apparatus may include fewer or greater number of components, and may incorporate some or all of the functionality described with respect to the source apparatus components shown in Figs. 7a and 7b. Accordingly, although the output voltage/current measurement module 401, input adapter (for voltage output) 402, one or more output connectors 403, input adapter (for current output) 404, Digital to Analog converter (DAC) 405, protection module 406, and Microcontroller Unit (MCU) 407 are illustrated as part of the source apparatus 400, no restrictions are placed on the location and control of components 401 - 407. In particular, in other embodiments, components 401 - 407 may be part of different entities, electronic systems or computing systems.

Depending on the embodiment, the apparatus 400, and one or more of the engines, modules or components comprised therein, may be implemented in software, as described above, or in hardware, such as an electronic circuit, an electronic component, or an application specific integrated circuit (ASIC), or in the form of a combination of hardware and software, such as for example a software program intended to be loaded and executed on a component of FPGA (Field Programmable Gate Array) type.

Advantages of the proposed schemes include in some embodiments that a high level of reliability can be achieved with a simple electronic design, using proven functional blocks, and a robust firmware, inspired by the coding rules of industrial systems: SIL4 ... SIL3 ..., or aeronautical systems: DAL A ... DAL B ..., or finally systems for medical use: Class 1 ... Class 2 .... These coding rules recommend, for example, a parsimonious use of loops, or a prohibition on the use of recursive functions.

In embodiments of the present subject disclosure, reliability may advantageously be reflected in the selection of the mode of operation, in voltage or current, according to criteria having a high certainty. In the case of multi-criteria choices, the margins of error will have minimal overlap.

While the invention has been described with respect to preferred embodiments, those skilled in the art will readily appreciate that various changes and/or modifications can be made to the invention without departing from the spirit or scope of the invention as defined by the appended claims.

Although this invention has been disclosed in the context of certain preferred embodiments, it should be understood that certain advantages, features and aspects of the systems, devices, and methods may be realized in a variety of other embodiments. Additionally, it is contemplated that various aspects and features described herein can be practiced separately, combined together, or substituted for one another, and that a variety of combination and sub-combinations of the features and aspects can be made and still fall within the scope of the invention. Furthermore, the systems and devices described above need not include all of the modules and functions described in the preferred embodiments.

Information and signals described herein can be represented using any of a variety of different technologies and techniques. For example, data, instructions, commands, information, signals, bits, symbols, and chips can be represented by voltages, currents, electromagnetic waves, magnetic fields or particles, optical fields or particles, or any combination thereof.

Depending on the embodiment, certain acts, events, or functions of any of the methods described herein can be performed in a different sequence, may be added, merged, or left out all together (e.g., not all described acts or events are necessary for the practice of the method). Moreover, in certain embodiments, acts or events may be performed concurrently rather than sequentially.

## Claims

1. A method for configuring a source apparatus adapted for processing an analog electrical output signal output to a receptor apparatus, the method comprising, the source apparatus being electrically coupled to the receptor apparatus through an output interface comprising a first and second output signal terminals of the source apparatus:
• Configuring the output interface of the source apparatus to be an analog current output;
• Obtaining one or more measured voltages respectively corresponding to one or more respective current values of a current signal injected in the receptor apparatus through the analog current output; and
• Performing a determination of a type of an analog electrical output signal to be output by the output interface, based on the one or more measured voltages.

2. The method according to claim 1, wherein performing the determination of the type of the analog electrical output signal output by the analog current output comprises: determining, based on the one or more measured voltages, that the output interface of the source apparatus is to be configured as an analog current output.

3. The method according to claim 2, further comprising: configure the output interface of the source apparatus to be an analog current output.

4. The method according to claim 1, wherein performing the determination of the type of the analog electrical output signal output by the analog current output comprises: determining, based on the one or more measured voltages, that the output interface of the source apparatus is to be configured as an analog voltage output.

5. The method according to claim 4, further comprising: configure the output interface of the source apparatus to be an analog voltage output.

6. The method according to claim 1, wherein performing the determination of the type of the analog electrical output signal output by the analog current output comprises: determining, based on the one or more measured voltages, whether the output interface of the source apparatus is to be configured as an analog current output or an analog voltage output.

7. The method according to claim 1, wherein performing the determination of the type of the analog electrical output signal output by the analog current output results in an error based on that no determination can be made as to whether the output interface of the source apparatus is to be configured as an analog current output or an analog voltage output.

8. The method according to any of the preceding claims, wherein the obtaining the one or more measured voltages comprises performing a configuration loop, which comprises:
• Configuring the analog current output to output a current signal of a predefined initial current value;
• Performing one or more iterations of the configuration loop, an iteration of the configuration loop comprising: for a present iteration current value of the current signal output by the analog current output, performing a current injection to the receptor apparatus of a current value corresponding to the present iteration current value, and obtaining a measured voltage by performing a voltage measurement of a voltage at the output interface of the source apparatus.

9. The method according to claim 8, wherein the iteration of the configuration loop further comprises: storing in a memory the measured voltage in association with the present iteration current value.

10. The method according to any of claims 8 - 9, wherein the iteration of the configuration loop further comprises:
• Based on determining that the present iteration current value is inferior to a predefined current threshold value, incrementing the present iteration current value by a predefined configuration loop current value step;
• Otherwise exiting the configuration loop.

11. The method according to any of the preceding claims, further comprising:
determining one or more scores respectively representing a current score, a voltage score, and an indetermined score based on the one or more measured voltages,
wherein the determination of the type of analog electrical output signal to be output by the output interface is based on the one or more scores.

12. The method according to claim 11, further comprising: determining, for an injected current value of the one or more respective current values of the current signal injected in the receptor apparatus, a representative voltage value based on the one or more measured voltages that correspond to the injected current value; wherein the determination of the type of analog electrical output signal to be output by the output interface comprises comparing the representative voltage value with a threshold.

13. An apparatus comprising a processor and a memory operatively coupled to the processor, wherein the apparatus is configured to perform a method according to any of claims 1 to 12.

14. A computer program product comprising computer program code tangibly embodied in a computer readable medium, said computer program code comprising instructions to, when provided to a computer system and executed, cause said computer to perform a method according to any of claims 1 to 12.

15. A data set representing, for example through compression or encoding, a computer program product according to claim 14.
